# EUROPEAN PATENT SPECIFICATION

(11) **EP 2 905 802 B1**
(45) Date of publication and mention of the grant of the patent: **22.05.2019**
(21) Application number: 14461507.7
(22) Date of filing: 07.02.2014
(51) Int. Cl.: H01J 37/32

(54) **Method of detecting arcs in a plasma process and power supply for supplying an output quantity to a plasma process**
Verfahren zur Lichtbogenerkennung in einem Plasmaprozess und Stromversorgung zur Bereitstellung einer Ausgangsmenge in einem Plasmaprozess
Procédé de détection d'arcs dans un traitement au plasma et alimentation électrique pour alimenter une quantité rendement vers un traitement au plasma

(43) Date of publication of application: 12.08.2015
(73) Proprietor: TRUMPF Huettinger Sp. Z o. o., 05-220 Zielonka (PL)
(72) Inventor: Lach, Piotr, 05-200 Wolomin (PL); Dr Zelechowski, Marcin, 01-710 Warsaw (PL); Gieraltowski, Andrzej, 05-200 Warszawa (PL); Kolasinski, Piotr, 03-813 Warszawa (PL)
(74) Representative: Kohler Schmid Möbus Patentanwälte

(56) References cited:
- WO-A2-2004/072754
- US-A1- 2006 049 831
- US-A1- 2006 241 879
- US-A1- 2008 021 664
- US-A1- 2010 141 221

## Description

The invention relates to a method of detecting arcs in a plasma process which is supplied by a power supply with an output quantity, wherein the output quantity is compared with an arc detection threshold value and an arc is detected if the output quantity passes the arc detection threshold value, wherein the arc detection threshold value is determined based on at least one set point for an output quantity.

The coating of substrates, e. g. glass, by cathode sputtering in plasma processes is well known. The sputtering can be done conventionally or using a reactive gas. In that case it is called reactive sputtering. To that end, a current or voltage source produces a plasma, which removes material from a target, which is then coated on the substrate, e. g. a glass substrate. If a reactive process is used, the target atoms can combine with gas atoms or molecules, depending on the desired coating.

In particular, if reactive processes are being used, arcs can occur in the plasma process. Such arcs can be detrimental to the plasma process and can even destroy the coating. Therefore, it is necessary to detect arcs quickly and reliably. Often, arcs are detected by monitoring the output voltage of the power supply. If there is a rapid fall in the output voltage, an arc is detected. On the other hand, the current can be monitored. If there is an instant rise in the output current, this is also indicative of an arc. In particular, output current and output voltage can be monitored and compared to a threshold value respectively. However, the output current and the output voltage may change during plasma processing for other reasons, i. e. without an arc occurring.

The power supply may be a current regulated and/or a voltage regulated and/or a power regulated power supply. Setpoint values for current, voltage or power are given from outside, for example by a user. The power supply is then regulated to achieve the setpoint values at the output. If, for example, the power supply is in the power regulation mode with a desired setpoint for the power, a maximum setpoint for the current, and a maximum setpoint for the voltage, it is difficult to determine a good threshold value for arc detection, because the absolute value for voltage or current are varying with plasma impedance. Hence, if a fixed threshold value is used to detect arcs, arc detection is not very reliable.

US 2006/0049831 A1 discloses a method and an apparatus for the detection and suppression of electrical arcing. Arcing is detected by monitoring whether an electrical signal, especially generated power, exceeds a predefined threshold. The threshold is based solely on a set point for that electrical signal, especially a set point for generated power.

US 2010/0141221 A1 discloses another method and apparatus for controlling an application of power to power a plasma chamber. The actual power out during the sampling interval is compared to a present power setting and a compensation value is generated. The power setting is adjusted according to this compensation value.

US 2006/0241879 A1 describes an arc defection circuitry that bases arc detection on a comparison of power-related signals with dynamically generated boundaries. The dynamic boundaries are derived from previous values of the power-related signals.

US 2008/0021664A1 and WO 2004/072754 A2 disclose further power supply circuitries for generating and controlling plasmas and related arc detection arrangements.

The object of the present invention is to provide a method and a power supply which allow faster and more reliable arc detection.

The problem is solved according to the invention by a method of detecting arcs in a plasma process which is supplied by a power supply with an output quantity, wherein the output quantity is compared with an arc detection threshold value, and an arc is detected if the output quantity passes the arc detection threshold value, wherein the arc detection threshold value is determined based on at least one setpoint for an output quantity characterized in that a first modified setpoint for a first output quantity is determined based on a measured second (different) output quantity and a setpoint of the second output quantity, wherein the arc detection threshold value is determined based on the first modified setpoint for a first output quantity. The arc detection threshold value is not a fixed value but varies with a setpoint for an output quantity. Output quantities are for example voltage or current. But also power is considered to be an output quantity in the sense of the present invention because the output power can be easily calculated from voltage and current. Setpoints for an output quantity such as a voltage setpoint, a current setpoint or a power setpoint can be given from the outside, for example by a user of the power supply. Hence, the first modified setpoint is not only determined based on a setpoint of an output quantity, but also on a measured output quantity. Therefore it is possible, to adjust the arc detection threshold value even during a running plasma process. It is therefore possible, to adjust the arc detection threshold value such that false arc detection can be avoided, which might in other cases occur due to a varying impedance of the plasma process. Much faster and more reliable arc detection can be achieved.

Furthermore, it is possible to determine a second modified setpoint for a first output quantity based on a first and second measured output quantity, and the setpoint of a third (different) output quantity, wherein the arc detection threshold value may be determined based on the second modified setpoint. This method step allows for an even more reliable arc detection .

For example, the first modified setpoint can be a modified current setpoint. This may be determined based on a setpoint for the output voltage. A second modified setpoint may also be a current setpoint. This could be determined based on a setpoint for the output power, a measured output voltage and a measured output current, which are supplied to the plasma process. Alternatively, a first modified voltage setpoint may be determined based on a setpoint for the output current. A second modified voltage setpoint may be determined based on a setpoint for the output power and the measured output voltage and the measured output current, which are supplied to the plasma process.

The first and second modified setpoint for an output quantity may be determined by a regulation unit respectively. For example, a PI regulation unit may be used.

An arc detection parameter may be determined by comparing the setpoint of the first output quantity, the first modified setpoint of the first output quantity and the second modified setpoint for the first output quantity. Advantageously, the arc detection parameter determined in this way can also be used as a setpoint for a power converter, which forms part of the power supply. The power converter inside the power supply may be current controlled or voltage controlled in order to achieve the setpoints of the output quantities at the output of the power supply. For a current controlled power converter, a first modified current setpoint may be calculated from a measured output voltage and a setpoint for the output voltage, and a second modified current setpoint may be calculated from a setpoint for the output power, the measured output voltage, and the measured output current.

For a voltage controlled power converter, a first modified voltage setpoint may be calculated from a measured output current and a setpoint for the output current, and a second modified voltage setpoint may be calculated from an output power setpoint, the measured output current and the measured output voltage.

The arc detection threshold value may be determined based on the arc detection parameter and a maximum output quantity offset. This offest may be set by a user and may in particular be given as percentage of an output quantity such as current, voltage or power. In particular, the arc detection threshold value may be calculated as arc detection parameter x (1 + maximum output quantity offset).

The arc detection threshold value may be weighted by multiplication with a factor, in particular a factor < 1.

As mentioned before, a power converter may be controlled based on the arc detection parameter.

For a power supply with a current controlled power converter, the output current may depend on the current setpoint, a first modified current setpoint and a second modified current setpoint. For a voltage controlled power converter, the output voltage may depend on an output voltage setpoint, a first modified output voltage setpoint and a second modified output voltage setpoint.

The arc detection threshold value may be adapted more slowly and/or with a delay than a set point of an output quantity, if the set point of the output quantity is changed. In other words, if the set point of an output quantity changes, the arc detection threshold value may change more slowly in order to avoid false arc detection. Alternatively or additionally the arc detection threshold value may change with a time delay after the set point has changed. In particular, if the set point for the output quantity is decreased, the arc detection threshold value may change at a slower rate compared to the set point and/or with a delay. On the other hand, if the set point for the output quantity increases, the arc detection threshold value may change at the same rate and/or immediately, i.e. react directly to a change in the set point.

The invention also relates to a power supply for supplying an output quantity to a plasma process, including an arc detection unit for comparing at least one power supply output quantity with an arc detection threshold value, the arc detection unit being connected to or being part of a control receiving at least one setpoint for an output quantity and being configured to determine the arc detection threshold value based on the at least one setpoint for an output quantity.

The control comprises an element for determining a first modified setpoint for a first output quantity based on a measured second output quantity and a setpoint of a second output quantity. Preferably, the control receives setpoints for an output voltage, an output current and an output power. Arcs can be detected much faster and more reliably with such a power supply. For example, the voltage setpoint and the measured output voltage may be used to determine a first modified current setpoint. Alternatively, an output current setpoint and measured output current may be used to determine a first modified voltage setpoint.

The element for determining a first modified setpoint for a first output quantity may be a regulation unit. For example, the element may be a PI regulation unit.

The control may comprise an element for determining a second modified setpoint for a first output quantity based on a first and second measured output quantity and a setpoint of a third output quantity. In particular, an output power may be calculated from a measured output current and a measured output voltage and the second modified setpoint will be determined based on the calculated output power and a setpoint for the output power.

The element for determining the second modified setpoint for a first output quantity may also be embodied as a regulation unit. In particular, the element may be embodied as a PI regulation unit.

Furthermore, a selection unit may be provided to select one of the setpoint, the first modified setpoint or the second modified setpoint, as an arc detection parameter. The selection unit may be configured to determine a minimum of the setpoint, the first modified setpoint and the second modified setpoint as arc detection parameter. The arc detection parameter may also be used as an input parameter for a power converter, in particular for a regulator of the power converter.

An arc detection threshold value determination unit may be provided for determining the arc detection threshold value based on the arc detection parameter and the maximum output quantity offset. In particular, the maximum output quantity offset may be added to the arc detection parameter.

Furthermore, the power supply may be provided with a selector which allows selecting the arc detection threshold value. In particular, an arc detection threshold value which is set manually by the user may be selected or an arc detection threshold value determined with the inventive method may be selected as arc detection threshold value.

The foregoing and other objects, features and advantages of the invention as well as the invention itself, will be more fully understood from the following illustrative description, when read together with the accompanying drawings, which are not necessarily to scale.
- Fig. 1: is a block diagram of a power supply.
- Fig. 2: is a very schematic representation of a control connected to an arc detection unit.
- Fig. 3: is a more detailed schematic diagram of the control.
- Fig. 4: is a diagram explaining arc detection with an arc detection threshold value.
- Fig. 5: is a flow chart for illustrating the inventive method.

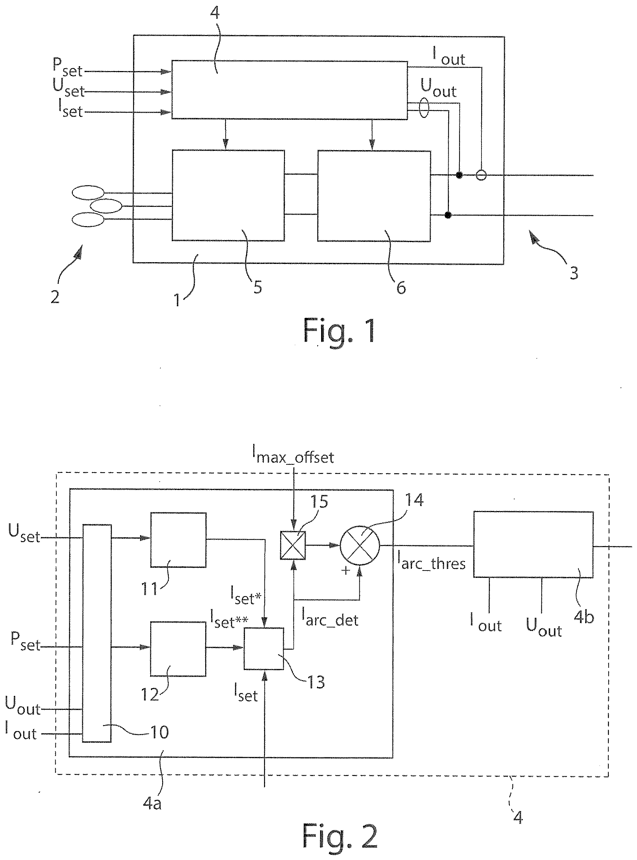

Fig. 1 shows a power supply 1 which receives at its input a voltage from a supply grid 2. The power supply generates output quantities at its output 3. Output quantities are typically an output current lout and an output voltage Uout. Multiplying output voltage and output current results in an output power Pout, which is also considered an output quantity.

The power supply 1 comprises a combined control and arc detection unit 4 which receives as an input setpoints for the output power (Pset), for the output voltage (Uset) and for the output current (Iset). Furthermore, the control and arc detection unit 4 comprises measuring means for measuring the output voltage and the output current. Based on the setpoints Pset, Iset, Uset for the output quantities the control and arc detection unit 4 produces a regulation quantity, which is fed to a power converter 5. The power converter 5 may be voltage controlled or current controlled. The power converter 5 is connected to an inverter 6, typically a bridge inverter. The bridge inverter 6 is also controlled by the control and arc detection unit 4.

The control and arc detection unit 4 is described in more detail in Fig. 2. In Fig. 2 only the elements are highlighted that are necessary for creating an arc detection threshold value. The control part 4a comprises an input unit 10, which receives in the shown embodiment setpoints for an output voltage Uset and an output power Pset as well as measured values for the output voltage and the output current Uout, lout. The input device 10 is connected to a first regulation unit 11 and a second regulation unit 12. The first regulation unit 11 produces a first modified setpoint (in this case Iset*) for an output quantity and the regulation unit 12 produces a second modified setpoint (in this case Iset**) for an output quantity. The first modified setpoint Iset* for an output quantity and the second modified setpoint Iset** for an output quantity as well as a setpoint Iset for the output quantity are input to a selection device 13. In particular, the selection device 13 may determine a minimum value of the setpoint Iset, the first modified setpoint Iset* and the second modified setpoint Iset**. The output quantity of the selection device 13 is called an arc detection parameter Iarc_det, which is then fed to an adder 14, and a multiplier 15 which also receives a maximum offset Imax_offset of an output quantity.

In the adder 14, an arc detection threshold value is produced which is input to an arc detection unit 4b. The arc detection unit 4b also receives the output current Iout and the output voltage Uout and can compare at least one of the output current lout or the output voltage Uout with the arc detection threshold value Iarc_thres in order to check if one of the measured output quantities exceeds or falls below the arc detection threshold value Iarc_thres. If an arc is detected by the arc detection unit 4b, an arc detection signal is generated and output to an arc extinction device (not shown). The arc detection unit 4b could be a separate unit and not be combined with the control parts 4a.

Obviously an Uarc_det and Uarc_thres can be obtained bases on Uset, Uset*, and Uset**.

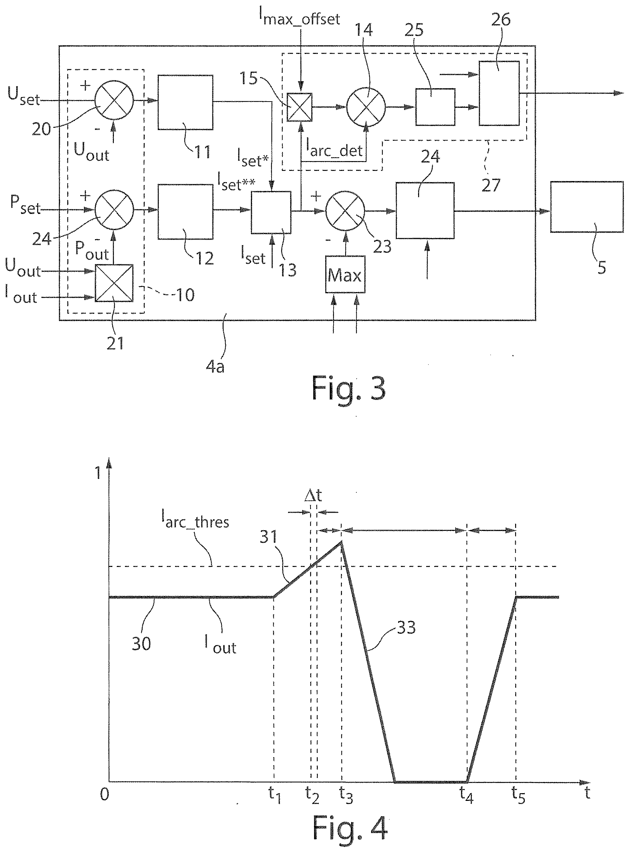

Fig. 3 is a more detailed representation of the control 4. Elements that have been previously described have the same reference numeral. From Fig. 3 it is clear that the input unit 10 comprises an element 20 for subtracting a measured output quantity Uout from the corresponding setpoint of the output quantity, for example, a measured voltage Uout is subtracted from a setpoint for an output voltage Uset. Furthermore, element 21 is provided for multiplying a measured output voltage Uout and a measured output current Iout. In that way the output power Pout is obtained, which is fed to element 24, which is used for subtracting the calculated output power Pout from a setpoint Pset for the output power. In that way, the input quantities for the regulation units 11, 12 are produced.

Furthermore, from Fig. 3 it becomes clear that the arc detection parameter Iarc_det produced by selection unit 13 is also fed to an adder 23 which produces an input quantity for the regulation unit 24, for example a PID regulation unit, which produces an input signal for the power converter 5. Furthermore, the value produced by the element 14 may be multiplied with a constant value in block 25 to produce the arc detection threshold value Iarc_thres.

Alternatively, block 25 may be implemented as a filter, which works as follows:
If the set point of an output quantity increases, the value produced by element 14 increases automatically directly, i.e. at the same rate and/or without delay, to the proper arc detection threshold value. If the set point of the output quantity decreases, to avoid false arc detection, filter 25 causes the arc detection threshold value to decrease more slowly than the set point and/or after a delay time. This avoids false arc detection.

Alternatively the filter works as follows:
If the set point of an output quantity increases, the value produced by element 14 increases at a first rate (for example with a first slope) and/or after a first delay, wherein the first rate may be slower than the rate of change of the set point, to the proper arc detection threshold value. If the set point of the output quantity decreases, to avoid false arc detection, filter 25 causes the arc detection threshold value to decrease at a second rate and/or after a second delay, wherein the second rate may be slower than the first rate and/or the second delay may be longer than the first delay.

A selection unit 26 may be used to select either an arc detection threshold value Iarc_thres produced by element 25 or an arc detection threshold value which is set manually by a user. The arc detection threshold value is then output to the arc detection unit, which is not shown in Fig. 3. Elements 14, 15, 25, 26 form an arc detection threshold determination unit 27.

Fig. 4 shows a diagram of an output current Iout, which is constant until t1, see 30. At time t1, an arc occurs, which leads to a rise in the output current, which is shown by line 31. At time t2 the output current passes the arc detection threshold value Iarc_thres. The arc is detected within a very short time detection time Δt, which is below 100 ns. After that, the power supply 1 is turned off until t3. In the time interal between t4 and t3, the arc is allowed to extinguish, which leads to a drop in the output current Iout as can be seen at 33. At time t4 the power supply 1 is switched on again such that the output current Iout is ramped up to the original level which is reached at t4.

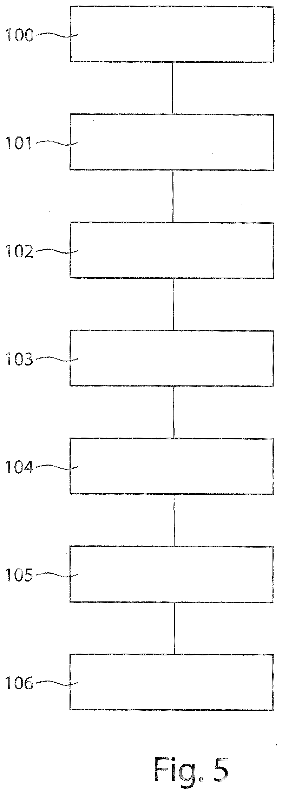

Fig. 5 shows a flow chart in order to explain the inventive method. According to step 100, a plasma process is supplied with an output quantity from a power supply. In step 101 at least one output quantity of of the power supply is being measured. In step 102 a first modified setpoint for a first output quantity is determined based on a measured second output quantity and a setpoint of a second output quantity. In step 103, a second modified setpoint for a first output quantity is determined based on a first and a second output quantity and a setpoint of a third output quantity. In step 104, a minimum value of the setpoint of an output quantity, the first modified setpoint of the output quantity and the second modified setpoint of the output quantity is determined. This value is multiplied with a maximum offset of the output quantity, and the result of the multiplication is added to the minimum determined previously in step 105. In the next process step 106 the result of the addition is multiplied (weighted) with a constant factor. The result is the arc detection threshold value which may then be used for arc detection, in particular for comparing with the measured output quantity.

## Claims

1. Method of detecting arcs in a plasma process which is supplied by a power supply (1) with an output quantity (Uout, Iout, Pout), wherein the output quantity (Uout, Iout, Pout) is compared with an arc detection threshold value (Iarc_thres, Uarc_thres) and an arc is detected if the output quantity (Uout, Iout, Pout) passes the arc detection threshold value (Iarc_thres, Uarc_thres), wherein the arc detection threshold value (Iarc_thres, Uarc_thres) is determined based on at least one set point (Iset, Uset, Pset) for an output quantity, **characterized in that** a first modified set point (Iset*, Uset*) for a first output quantity (Uout, Iout) is determined based on a measured second output quantity (Uout, Iout) and a set point (Iset, Uset) of the second output quantity (Uout, Iout), wherein the arc detection threshold value (Iarc_thres, Uarc_thres) is determined based on the first modified set point (Iset*, Uset*).

2. Method according to claim 1, **characterized in that** a second modified set point (Iset**, Uset**) for a first output quantity (Uout, Iout) is determined based on a first and second measured output quantity (Uout, Iout) and a set point (Pset) of a third output quantity (Pout) wherein the arc detection threshold value (Iarc_thres, Uarc_thres) is determined based on the second modified set point (Iset**, Uset**).

3. Method according to any of the preceding claims, **characterized in that** the first and second modified setpoint (Iset*, Uset*, Iset**, U**) for an output quantity (Iout, Uout) are determined by a regulation unit (11, 12) respectively.

4. Method according to any of the preceding claims, **characterized in that** an arc detection parameter (Iarc_det, Uarc_det) is determined by comparing the set point (Iset, Uset) of the first output quantity, the first modified set point (Iset*, Uset*) of the first output quantity and the second modified set point (Iset**, Uset**) of the first output quantity.

5. Method according to claim 4, **characterized in that** the arc detection threshold value (Iarc_thres, Uarc_thres) is determined based on the arc detection parameter (Iarc_det, Uarc_det) and a maximum output quantity offset (Imax_offset, Umax_offset).

6. Method according to any of the preceding claims, **characterized in that** a power converter (5) is controlled based on the arc detection parameter (Iarc_det, Uarc_det).

7. Method according to any of the preceding claims, **characterized in that** the arc detection threshold value is adapted more slowly than a set point of an output quantity and/or with a delay, if the set point of the output quantity is changed.

8. Power supply (1) for supplying an output quantity (Iout, Uout, Pout) to a plasma process, including an arc detection unit (4b) adapted to compare at least one power supply output quantity (lout, Uout, Pout) with an arc detection threshold value (Iarc_thres, Uarc_thres), the arc detection unit (4b) being connected to or part of a control (4) receiving at least one set point (Iset, Uset, Pset) for an output quantity and being configured to determine the arc detection threshold value (Iarc_thres, Uarc_thres) based on the at least one set point (Iset, Uset, Pset) for an output quantity, **characterized in that** the control (4) comprises an element adapted to determine a first modified set point (Iset*, Uset*) for a first output quantity (Uout, Iout) based on a measured second output quantity (Uout, Iout) and a set point (Iset, Uset) of the second output quantity (Uout, Iout).

9. Power supply according to claim 8 **characterized in that** the element for determining a first modified set point (Iset*, Uset*) for a first output quantity (Uout, Iout) is a regulation unit (11).

10. Power supply according to any of the preceding claims 8-9, **characterized in that** the control (4) comprises an element adapted to determine a second modified set point (Iset**, Uset**) for a first output quantity (Uout, lout) based on a first and second measured output quantity (Uout, Iout) and a set point (Pset) of a third output quantity (Pout).

11. Power supply according to any of the preceding claims 8-10, **characterized in that** the element adapted to determine the second modified set point (Iset**, Uset**) for a first output quantity (Uout, Iout) is a regulation unit (12).

12. Power supply according to any of the preceding claims 8-11, **characterized in that** a selection unit (13) is provided to select one of the set point (Iset, Uset, Pset), first modified set point (Iset*, Uset*, Pset*) or second modified set point (Iset**, Uset**, Pset**) as arc detection parameter (Iarc_det, Uarc_det).

13. Power supply according to any of the preceding claims 8-12, **characterized in that** an arc detection threshold value determination unit (27) is provided, adapted to determine the arc detection threshold value based on the arc detection parameter (Iarc_det, Uarc_det) and a maximum output quantity offset (Imax_offset, Umax_offset).

## Patentansprüche

1. Verfahren zum Erkennen von Arcs in einem Plasmaprozess, der durch eine Leistungsversorgung (1) mit einer Ausgangsgröße (Uout, lout, Pout) versorgt wird, wobei die Ausgangsgröße (Uout, lout, Pout) mit einem Arcerkennungsschwellenwert (Iarc_thres, Uarc_thres) verglichen wird und ein Arc erkannt wird, wenn die Ausgangsgröße (Uout, lout, Pout) den Arcerkennungsschwellenwert (larc_thres, Uarc_thres) überschreitet, wobei der Arcerkennungsschwellenwert (Iarc_thres, Uarc_thres) basierend auf wenigstens einem Sollwert (Iset, Uset, Pset) für eine Ausgangsgröße bestimmt wird, **dadurch gekennzeichnet, dass** ein erster modifizierter Sollwert (Iset*, Uset*) für eine erste Ausgangsgröße (Uout, lout) basierend auf einer gemessenen zweiten Ausgangsgröße (Uout, lout) und einem Sollwert (Iset, Uset) der zweiten Ausgangsgröße (Uout, lout) bestimmt wird, wobei der Arcerkennungsschwellenwert (Iarc_thres, Uarc_thres) basierend auf dem ersten modifizierten Sollwert (Iset*, Uset*) bestimmt wird.

2. Verfahren nach Anspruch 1, **dadurch gekennzeichnet, dass** ein zweiter modifizierter Sollwert (Iset**, Uset**) für eine erste Ausgangsgröße (Uout, lout) basierend auf einer ersten und einer zweiten gemessenen Ausgangsgröße (Uout, lout) und einem Sollwert (Pset) einer dritten Ausgangsgröße (Pout) bestimmt wird, wobei der Arcerkennungsschwellenwert (larc_thres, Uarc_thres) basierend auf dem zweiten modifizierten Sollwert (Iset**, Uset**) bestimmt wird.

3. Verfahren nach einem der vorhergehenden Ansprüche, **dadurch gekennzeichnet, dass** der erste und der zweite modifizierte Sollwert (Iset*, Uset*, Iset**, U**) für eine Ausgangsgröße (lout, Uout) durch jeweils eine Regeleinheit (11, 12) bestimmt werden.

4. Verfahren nach einem der vorhergehenden Ansprüche, **dadurch gekennzeichnet, dass** ein Arcerkennungsparameter (Iarc_det, Uarc_det) durch Vergleichen des Sollwerts (Iset, Uset) der ersten Ausgangsgröße, des ersten modifizierten Sollwerts (Iset*, Uset*) der ersten Ausgangsgröße und des zweiten modifizierten Sollwerts (Iset**, Uset**) der ersten Ausgangsgröße bestimmt wird.

5. Verfahren nach Anspruch 4, **dadurch gekennzeichnet, dass** der Arcerkennungsschwellenwert (Iarc_thres, Uarc_thres) basierend auf dem Arcerkennungsparameter (Iarc_det, Uarc_det) und einem maximalen Ausgangsgrößenversatz (Imax_offset, Umax_offset) bestimmt wird.

6. Verfahren nach einem der vorhergehenden Ansprüche, **dadurch gekennzeichnet, dass** ein Leistungswandler (5) basierend auf dem Arcerkennungsparameter (larc_det, Uarc_det) gesteuert wird.

7. Verfahren nach einem der vorhergehenden Ansprüche, **dadurch gekennzeichnet, dass** der Arcerkennungsschwellenwert langsamer als ein Sollwert einer Ausgangsgröße und/oder mit einer Verzögerung angepasst wird, wenn der Sollwert der Ausgangsgröße geändert wird.

8. Leistungsversorgung (1) zum Liefern einer Ausgangsgröße (lout, Uout, Pout) an einen Plasmaprozess, umfassend eine Arcerkennungseinheit (4b), die zum Vergleichen wenigstens einer Leistungsversorgungsausgangsgröße (lout, Uout, Pout) mit einem Arcerkennungsschwellenwert (larc_thres, Uarc_thres) eingerichtet ist, wobei die Arcerkennungseinheit (4b) mit einer Steuervorrichtung oder einem Teil dieser (4) verbunden ist, die wenigstens einen Sollwert (Iset, Uset, Pset) für eine Ausgangsgröße empfängt, und konfiguriert ist, um den Arcerkennungsschwellenwert (Iarc_thres, Uarc_thres) basierend auf dem wenigstens einen Sollwert (Iset, Uset, Pset) für eine Ausgangsgröße zu bestimmen, **dadurch gekennzeichnet, dass** die Steuervorrichtung (4) ein Element umfasst, das eingerichtet ist, um einen ersten modifizierten Sollwert (Iset*, Uset*) für eine erste Ausgangsgröße (Uout, lout) basierend auf einer gemessenen zweiten Ausgangsgröße (Uout, lout) und einem Sollwert (Iset, Uset) der zweiten Ausgangsgröße (Uout, lout) zu bestimmen.

9. Leistungsversorgung nach Anspruch 8, **dadurch gekennzeichnet, dass** das Element zum Bestimmen eines ersten modifizierten Sollwerts (Iset*, Uset*) für eine erste Ausgangsgröße (Uout, lout) eine Regeleinheit (11) ist.

10. Leistungsversorgung nach einem der vorhergehenden Ansprüche 8-9, **dadurch gekennzeichnet, dass** die Steuervorrichtung (4) ein Element umfasst, das eingerichtet ist, um einen zweiten modifizierten Sollwert (Iset**, Uset**) für eine erste Ausgangsgröße (Uout, lout) basierend auf einer ersten und einer zweiten gemessenen Ausgangsgröße (Uout, lout) und einem Sollwert (Pset) einer dritten Ausgangsgröße (Pout) zu bestimmen.

11. Leistungsversorgung nach einem der vorhergehenden Ansprüche 8-10, **dadurch gekennzeichnet, dass** das Element, das eingerichtet ist, um den zweiten modifizierten Sollwert (Iset**, Uset**) für eine erste Ausgangsgröße (Uout, lout) zu bestimmen, eine Regeleinheit (12) ist.

12. Leistungsversorgung nach einem der vorhergehenden Ansprüche 8-11, **dadurch gekennzeichnet, dass** eine Auswahleinheit (13) vorgesehen ist, um den Sollwert (Iset, Uset, Pset), den ersten modifizierten Sollwert (Iset*, Uset*, Pset*) oder den zweiten modifizierten Sollwert (Iset**, Uset**, Pset**) als Arcerkennungsparameter (Iarc_det, Uarc_det) auszuwählen.

13. Leistungsversorgung nach einem der vorhergehenden Ansprüche 8-12, **dadurch gekennzeichnet, dass** eine Bestimmungseinheit (27) für einen Arcerkennungsschwellenwert vorgesehen ist, die eingerichtet ist, um den Arcerkennungsschwellenwert basierend auf dem Arcerkennungsparameter (Iarc_det, Uarc_det) und einem maximalen Ausgangsgrößenversatz (lmax_offset, Umax_offset) zu bestimmen.

## Revendications

1. Procédé de détection d'arcs dans un traitement au plasma qui est alimenté par un bloc d'alimentation (1) avec une quantité de sortie (Uout, Iout, Pout), la quantité de sortie (Uout, Iout, Pout) étant comparée à une valeur seuil de détection d'arc (larc_thres, Uarc_thres) et un arc étant détecté si la quantité en sortie (Uout, Iout, Pout) dépasse la valeur seuil de détection d'arc (larc_thres, Uarc_thres), la valeur seuil de détection d'arc (Iarc_thres, Uarc_thres) étant déterminée sur la base d'au moins un point de consigne (Iset, Uset, Pset) pour une quantité de sortie, **caractérisé en ce qu'**un premier point de consigne modifié (Iset*, Uset*) pour une première quantité de sortie (Uout, Iout) est déterminé sur la base d'une deuxième quantité de sortie mesurée (Uout, Iout) et un point de consigne (Iset, Uset) de la deuxième quantité de sortie (Uout, Iout), la valeur seuil de détection d'arc (Iarc_thres, Uarc_thres) étant déterminée sur la base du premier point de consigne modifié (Iset*, Uset*).

2. Procédé selon la revendication 1, **caractérisé en ce qu'**un second point de consigne modifié (Iset**, Use**) pour une première quantité de sortie (Uout, Iout) est déterminé sur la base d'une première et d'une deuxième quantité de sortie mesurée (Uout, Iout) et un point de consigne (Pset) d'une troisième quantité de sortie (Pout), la valeur seuil de détection d'arc (Iarc_thres, Uarc_thres) étant déterminée sur la base du second point de consigne modifié (Iset**, Uset**).

3. Procédé selon l'une quelconque des revendications précédentes, **caractérisé en ce que** les premier et second points de réglage modifiés (Iset*, Uset*, Iset**, U**) pour une quantité de sortie (lout, Uout) sont déterminés par une unité de régulation (11, 12) respectivement.

4. Procédé selon l'une quelconque des revendications précédentes, **caractérisé en ce qu'**un paramètre de détection d'arc (larc_det, Uarc_det) est déterminé en comparant le point de consigne (Iset, Uset) de la première quantité de sortie, le premier point de consigne modifié (Iset*, Uset*) de la première quantité de sortie et le second point de consigne modifié (Iset **, Uset **) de la première quantité de sortie.

5. Procédé selon la revendication 4, **caractérisé en ce que** la valeur seuil de détection d'arc (Iarc_thres, Uarc_thres) est déterminée sur la base du paramètre de détection d'arc (Iarc_det, Uarc_det) et d'un décalage de quantité de sortie maximum (lmax_offset, Umax_offset).

6. Procédé selon l'une quelconque des revendications précédentes, **caractérisé en ce qu'**un convertisseur de puissance (5) est commandé sur la base du paramètre de détection d'arc (larc_det, Uarc_det).

7. Procédé selon l'une quelconque des revendications précédentes, **caractérisé en ce que** la valeur seuil de détection d'arc est conçue plus lentement qu'un point de consigne d'une quantité de sortie et/ou avec un retard, si le point de consigne de la quantité de sortie est modifié.

8. Bloc d'alimentation (1) destiné à fournir une quantité de sortie (Iout, Uout, Pout) à un traitement au plasma, incluant une unité de détection d'arc (4b) conçue pour comparer au moins une quantité de sortie de bloc d'alimentation (Iout, Uout, Pout) à une valeur seuil de détection d'arc (Iarc_thres, Uarc_thres), l'unité de détection d'arc (4b) étant reliée à une commande (4) ou à une partie de celle-ci recevant au moins un point de consigne (Iset, Uset, Pset) pour une quantité de sortie et étant configurée pour déterminer la valeur seuil de détection d'arc (Iarc_thres, Uarc_thres) sur la base de l'au moins un point de consigne (Iset, Uset, Pset) pour une quantité de sortie, **caractérisé en ce que** la commande (4) comprend un élément conçu pour déterminer un premier point de consigne modifié (Iset*, Uset*) pour une première quantité de sortie (Uout, Iout) sur la base d'une deuxième quantité de sortie mesurée (Uout, Iout) et d'un point de consigne (Iset, Uset) de la seconde quantité de sortie (Uout, Iout).

9. Bloc d'alimentation selon la revendication 8, **caractérisé en ce que** l'élément destiné à déterminer un premier point de consigne modifié (Iset*, Uset*) pour une première quantité de sortie (Uout, Iout) est une unité de régulation (11).

10. Bloc d'alimentation selon l'une quelconque des revendications précédentes 8 à 9, **caractérisé en ce que** la commande (4) comprend un élément conçu pour déterminer un second point de consigne modifié (Iset**, Uset**) pour une première quantité de sortie (Uout, Iout) sur la base d'une première et d'une deuxième quantité de sortie mesurée (Uout, Iout) et d'un point de consigne (Pset) d'une troisième quantité de sortie (Pout).

11. Bloc d'alimentation selon l'une quelconque des revendications précédentes 8 à 10, **caractérisé en ce que** l'élément conçu pour déterminer le second point de consigne modifié (Iset**, Uset**) pour une première quantité de sortie (Uout, Iout) est une unité de régulation (12).

12. Bloc d'alimentation selon l'une quelconque des revendications précédentes 8 à 11, **caractérisée en ce qu'**une unité de sélection (13) est prévue pour sélectionner l'un du point de consigne (Iset, Uset, Pset), le premier point de consigne modifié (Iset*, Uset*, Pset*) ou le second point de consigne modifié (Iset**, Uset**, Pset**) en tant que paramètre de détection d'arc (larc_det, Uarc_det).

13. Bloc d'alimentation selon l'une quelconque des revendications précédentes 8 à 12, **caractérisé en ce qu'**une unité de détermination de valeur seuil de détection d'arc (27), est prévue, conçue pour déterminer la valeur seuil de détection d'arc sur la base du paramètre de détection d'arc (larc_det, Uarc_det) et d'un décalage de quantité de sortie maximum (lmax_offset, Umax_offset).
